# EUROPEAN PATENT APPLICATION

(11) **EP 2 573 798 A2**
(43) Date of publication of application: **27.03.2013**
(21) Application number: 12186064.7
(22) Date of filing: 26.09.2012
(51) Int. Cl.: H01J 37/32

(54) **Microwave processing apparatus and method for processing object**

(30) Priority: 26.09.2011 JP 2011208487
(71) Applicant: TOKYO ELECTRON LIMITED, Minato-ku Tokyo 107-6325 (JP)
(72) Inventor: Ashida, Mitsutoshi, Yamanashi 407-0192 (JP)
(74) Representative: HOFFMANN EITLE

(57) **Abstract**

A microwave processing apparatus includes a processing chamber which accommodates an object to be processed, and a microwave introducing unit which has at least one microwave source to generate a microwave used to process the object and introduces the microwave into the processing chamber. The microwave processing apparatus further includes a control unit which controls the microwave introducing unit. Furthermore, the control unit changes a frequency of the microwave during a state of processing the object.

## Description

### Field of the Invention

The present invention relates to a microwave processing apparatus which performs predetermined treatment by introducing a microwave into a processing chamber, and a method for processing an object to be processed using the microwave processing apparatus.

### Background of the Invention

In a manufacturing process of semiconductor devices, various heat treatments such as film formation, etching, oxidation/diffusion, modification, annealing and the like are performed on a semiconductor wafer as a substrate to be processed. Such heat treatments are generally performed by heating the semiconductor wafer by using a substrate processing apparatus including a heater or a heating lamp.

In recent years, as an apparatus performing heat treatment on the semiconductor wafer, there is known an apparatus using a microwave instead of a heater or a lamp. For example, Japanese Patent Application Publication No. 2009-516375 (JP2009-516375A) describes a heat treatment system which performs hardening, annealing and film formation by using microwave energy. Further, Japanese Patent Application Publication No. 2010-129790 (JP2010-129790A) describes a heat treatment apparatus for forming a thin film by heating a film forming material by irradiating an electromagnetic wave (microwave) onto a semiconductor wafer having a film forming material layer formed on a surface thereof. In such microwave processing apparatuses, especially, it is possible to form a thin active layer while suppressing diffusion of impurities, or restore a lattice defect.

In the microwave processing apparatus, the output (power) of the microwave is determined by a voltage or a current supplied to a microwave source for generating the microwave. Japanese Patent Application Publication No. 1992-160791 (JPH4-160791A) describes that a magnitude of an output of a radio wave (microwave) is determined by a magnitude of an anode current of a magnetron. Further, Japanese Patent Application Publication No. 1998-241585 (JP H10-241585A) describes that an output of a microwave is controlled by varying a potential applied to the end hat (electrode) of a magnetron.

A microwave introduced into a processing chamber forms a standing wave in the processing chamber. If positions of nodes and antinodes of the standing wave are fixed while an object is being processed, there is a possibility of non-uniform process for the object, such as non-uniform heating.

### Summary of the Invention

In view of the above, the present invention provides a microwave processing apparatus which is capable of performing a uniform process on an object to be processed, and a method for processing the object using the microwave processing apparatus.

In accordance with a first aspect of the present invention, there is provided a microwave processing apparatus including: a processing chamber which accommodates an object to be processed; a microwave introducing unit which has at least one microwave source to generate a microwave used to process the object and introduces the microwave into the processing chamber; and a control unit which controls the microwave introducing unit, wherein the control unit changes a frequency of the microwave during a state of processing the object.

In accordance with a second aspect of the present invention, there is provided a method for processing an object to be processed by using a microwave processing apparatus including a processing chamber which accommodates the object, and a microwave introducing unit which has at least one microwave source to generate a microwave used to process the object and introduces the microwave into the processing chamber, the method including changing a frequency of the microwave during a state of processing the object.

### Brief Description of the Drawings

The objects and features of the present invention will become apparent from the following description of embodiments, given in conjunction with the accompanying drawings, in which:
FIG. 1 is a cross sectional view showing a schematic configuration of a microwave processing apparatus in accordance with an embodiment of the present invention;
FIG. 2 is an explanatory view showing a schematic configuration of a high voltage power supply unit of a microwave introducing unit in accordance with an embodiment of the present invention;
FIG. 3 is a circuit diagram illustrating an example of a circuit configuration of the high voltage power supply unit of the microwave introducing unit in accordance with the embodiment of the present invention;
FIG. 4 is a plan view depicting a top surface of a ceiling portion of the processing chamber shown in FIG. 1;
FIG. 5 is an explanatory view representing a configuration of a control unit shown in FIG. 1;
FIG. 6 is an explanatory view schematically showing voltage waveforms for generating a pulsed microwave in a first form of changing the frequency of the microwave; and
FIG. 7 is an explanatory diagram schematically showing a voltage waveform for generating a microwave in a second form of changing the frequency of the microwave.

### Detailed Description of the Embodiments

### [Microwave Processing Apparatus]

Hereinafter, an embodiment of the present invention will be described in detail with reference to the accompanying drawings which form a part hereof.

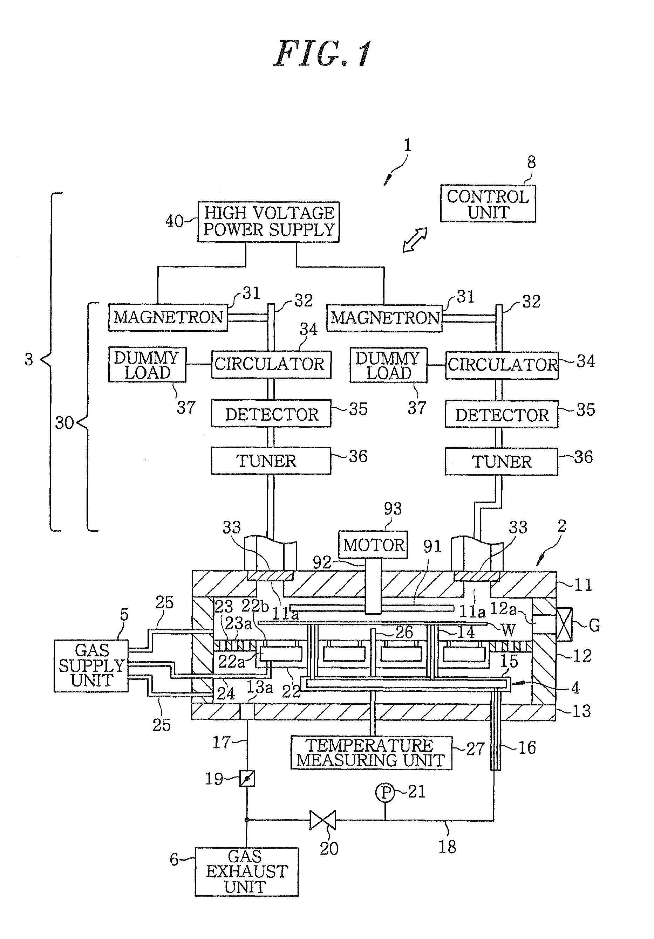

First, a schematic configuration of a microwave processing apparatus in accordance with an embodiment of the present invention will be described with reference to FIG. 1. FIG. 1 is a cross sectional view showing a schematic configuration of the microwave processing apparatus in accordance with the present invention. The microwave processing apparatus 1 in accordance with the present embodiment performs predetermined treatment such as film formation, modification, an annealing and the like by irradiating microwaves onto, e.g., a semiconductor wafer W for fabrication of a semiconductor device (hereinafter, simply referred to as "wafer") through a plurality of continuous operations.

The microwave processing apparatus 1 includes: a processing chamber 2 for accommodating a wafer W as a substrate to be processed; a microwave introducing unit 3 for introducing a microwave into the processing chamber 2; a supporting unit 4 for supporting the wafer W in the processing chamber 2; a gas supply unit 5 for supplying a gas into the processing chamber 2; a gas exhaust unit 6 for evacuating the processing chamber 2 to reduce the pressure therein, and a control unit 8 for controlling each component of the microwave processing apparatus 1. As for the unit for supplying a gas into the processing chamber 2, an external gas supply device which is not included in the microwave processing apparatus 1 may be used instead of the gas supply unit 5.

### <Processing Chamber>

The processing chamber 2 is formed in, e.g., a substantially cylindrical shape. The processing chamber 2 is made of metal. As for a material forming the processing chamber 2, e.g., aluminum, aluminum alloy, stainless steel or the like may be used. Further, the processing chamber 2 may be formed in, e.g., a rectangular column shape, other than a cylindrical shape. The microwave introducing unit 3 is provided at a top portion of the processing chamber 2 and serves as a microwave introducing mechanism for introducing an electromagnetic wave (microwave) into the processing chamber 2. A configuration of the microwave introducing unit 3 will be described in detail later.

The processing chamber 2 has a plate-shaped ceiling portion 11, a plate-shaped bottom portion 13, a sidewall portion 12 for connecting the ceiling portion 11 and the bottom portion 13, a plurality of microwave inlet ports 11a provided to vertically pass through the ceiling portion 11, a loading/unloading port 12a provided at the sidewall portion 12, and a gas exhaust port 13a provided at the bottom portion 13. The loading/unloading port 12a allows the wafer W to be loaded and unloaded between the processing chamber 2 and a transfer chamber (not shown) adjacent thereto. A gate valve G is provided between the processing chamber 2 and the transfer chamber (not shown). The gate valve G serves to open and close the loading/unloading port 12a. The gate valve G in a closed state airtightly seals the processing chamber 2 and the gate valve G in an open state allows the wafer W to be transferred between the processing chamber 2 and the transfer chamber (not shown).

### <Supporting unit>

The supporting unit 4 has a plate-shaped hollow lift plate 15 placed in the processing chamber 2, a plurality of pipe-shaped support pins 14 extending upward from the top surface of the lift plate 15, and a pipe-shaped shaft 16 extending from the bottom portion 13 of the lift plate 15 to the outside of the processing chamber 2 while penetrating the bottom portion 13. The shaft 16 is fixed to an actuator (not shown) outside the processing chamber 2.

The plurality of support pins 14 supports the wafer W while being in contact with the wafer W in the processing chamber 2. The support pins 14 are arranged such that their upper ends are aligned side by side in the circumferential direction of the wafer W. Further, the support pins 14, the lift plate 15 and the shaft 16 are configured to vertically move the wafer W by using the actuator (not shown).

Further, the support pins 14, the lift plate 15 and the shaft 16 are configured to allow the wafer W to be adsorbed onto the support pins 14 by the gas exhaust unit 6. Specifically, each of the support pins 14 and the shaft 16 has a pipe shape communicating with an inner space of the lift plate 15. Further, adsorption holes for sucking the backside of the wafer W are formed at upper end portions of the support pins 14.

The support pins 14 and the lift plate 15 are made of a dielectric material. The support pins 14 and the lift plate 15 may also be made of, e.g., quartz, ceramics or the like.

### <Gas Exhaust Unit>

The microwave processing apparatus 1 further includes a gas exhaust line 17 for connecting the gas exhaust port 13a and the gas exhaust unit 6, a gas exhaust line 18 for connecting the shaft 16 and the gas exhaust line 17, a pressure control valve 19 provided on the gas exhaust line 17, and an opening/closing valve 20 and a pressure gauge 21 provided on the gas exhaust line 18. The gas exhaust line 18 is directly or indirectly connected to the shaft 16 so as to communicate with the inner space of the shaft 16. The pressure control valve 19 is provided between the gas exhaust port 13a and the connection node between the gas exhaust lines 17 and 18.

The gas exhaust unit 6 has a vacuum pump such as a dry pump or the like. By operating the vacuum pump of the gas exhaust unit 6, the inside of the processing chamber 2 is vacuum-evacuated. At this time, the opening/closing valve 20 opens, so that the wafer W can be fixed by the supporting pins 14 by suction on the backside thereof.

### <Gas Introducing Mechanism>

The microwave processing apparatus 1 further includes: a shower head 22 disposed below the portion where the wafer W will be located in the processing chamber 2, an annular rectifying plate 23 disposed between the shower head 22 and the sidewall 12; a line 24 for connecting the shower head 22 and the gas supply unit 5; and a plurality of lines 25 connected to the gas supply unit 5 for introducing a processing gas into the processing chamber 2.

The shower head 22 cools the wafer W by a cooling gas in the case of processing the wafer W at a relatively low temperature. The shower head 22 includes: a gas channel 22a communicating with the line 24; and a plurality of gas injection openings 22b, communicating with the gas channel 22a, for injecting a cooling gas toward the wafer W. In the example shown in Fig. 1, the gas injection openings 22b are formed at a top surface of the shower head 22. The shower head 22 is made of a dielectric material having a low dielectric constant. The shower head 22 may be made of, e.g., quartz, ceramic or the like. The shower head 22 is not necessary for the microwave processing apparatus 1 and thus can be omitted.

The rectifying plate 23 has a plurality of rectifying openings 23a penetrating therethrough in a vertical direction. The rectifying plate 23 rectifies an atmosphere of the region where the wafer W will be placed in the processing chamber 2 and allows it to flow toward the gas exhaust port 13a.

The gas supply unit 5 is configured to supply a processing gas or a cooling gas, e.g., N₂, Ar, He, Ne, O₂, H₂, or the like. When the microwave processing apparatus 1 performs film formation, the gas supply unit 5 supplies a film forming material gas into the processing chamber 2.

Although it is not shown, the microwave processing apparatus 1 includes mass flow controllers and opening/closing valves provided on the lines 24 and 25. The types of gases supplied to the shower head 22 and the processing chamber 2 or the flow rates thereof are controlled by the mass flow controllers and the opening/closing valves.

### <Temperature Measuring Unit>

The microwave processing apparatus 1 further includes a plurality of radiation thermometers 26 for measuring a surface temperature of the wafer W and a temperature measuring unit 27 connected to the radiation thermometers 26. In Fig. 1, the illustration of the radiation thermometers 26 except the radiation thermometer 26 for measuring a surface temperature of a central portion of the wafer W is omitted. The radiation thermometers 26 are extended from the bottom portion 13 to the portion where the wafer W will be located such that the upper end portions thereof are positioned close to the rear surface of the wafer W.

### <Microwave Stirring Mechanism>

The microwave processing apparatus 1 further includes: a stirrer fan 91 disposed above the portion where the wafer W will be located in the processing chamber 2, formed of a plurality of fans; a rotary motor 93 provided outside the processing chamber 2; and a rotational shaft 92 for connecting the stirrer fan 91 and the rotary motor 93 while penetrating the ceiling portion 11. The stirring fan 91 is rotated to reflect and stir the microwaves introduced into the processing chamber 2. The stirring fan 91 has, e.g., four fans. The stirring fan 91 is made of a dielectric material having a low dielectric loss tangent (tanδ) in order to prevent the microwaves colliding with the stirring fan 91 from being absorbed or being transformed into a heat. The stirring fan 91 can be made of, e.g., a complex ceramics formed of metal or lead zirconate titanate (PZT), quartz, sapphire, or the like. Besides, the position of the stirring fan 91 is not limited to that shown in Fig. 1. For example, the stirring fan 91 can be provided below the portion where the wafer W will be located.

### <Control Unit>

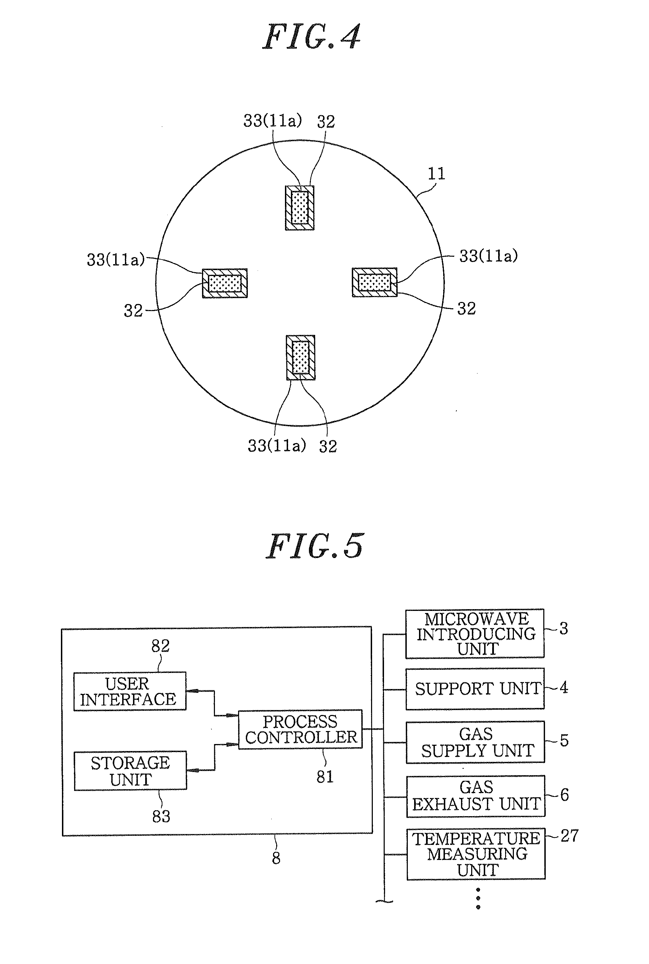

Each component of the microwave processing apparatus 1 is connected to and controlled by the control unit 8. The control unit 8 is typically a computer. FIG. 5 illustrates the configuration of the control unit 8 shown in FIG. 1. In the example shown in FIG. 5, the control unit 8 includes a process controller 81 having a central processing unit (CPU), and a user interface 82 and a storage unit 83 which are connected to the process controller 81.

The process controller 81 integrally controls the components of the microwave processing apparatus 1 (e.g., the microwave introducing unit 3, the supporting unit 4, the gas supply unit 5, the gas exhaust unit 6 and the temperature measuring unit 27 and the like) which relate to the processing conditions such as a temperature, a pressure, a gas flow rate, an output of a microwave and the like.

The user interface 82 includes a keyboard or a touch panel through which a process manager inputs commands to manage the microwave processing apparatus 1, a display for displaying an operation status of the microwave processing apparatus 1, or the like.

The storage unit 83 stores therein programs (software) for implementing various processes performed by the microwave processing apparatus 1 under the control of the process controller 81, and recipes in which processing condition data and the like are recorded. The process controller 81 executes a control programs or a recipe retrieved from the storage unit 83 in response to an instruction from the user interface 82 when necessary. Accordingly, a desired process is performed in the processing chamber 2 of the microwave processing apparatus 1 under the control of the process controller 81.

The control programs and the recipes may be stored in a computer-readable storage medium, e.g., a CD-ROM, a hard disk, a flexible disk, a flash memory, a DVD, a Blu-ray disc, or the like. Further, the recipes may be transmitted on-line from another device via, e.g., a dedicated line, whenever necessary.

### <Microwave Introducing Unit>

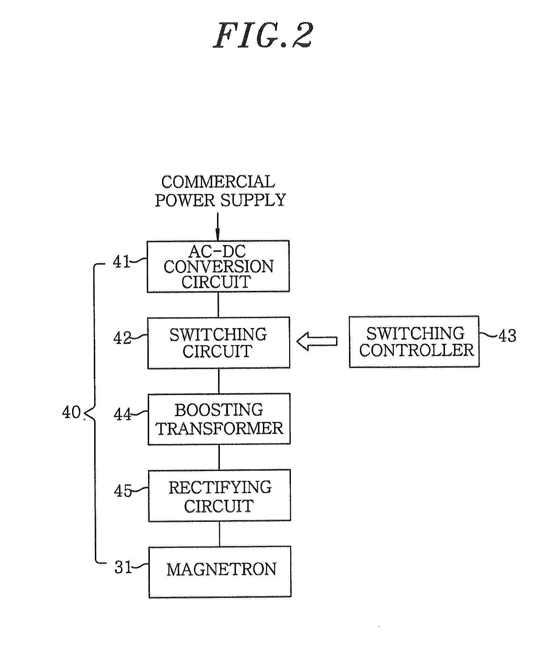

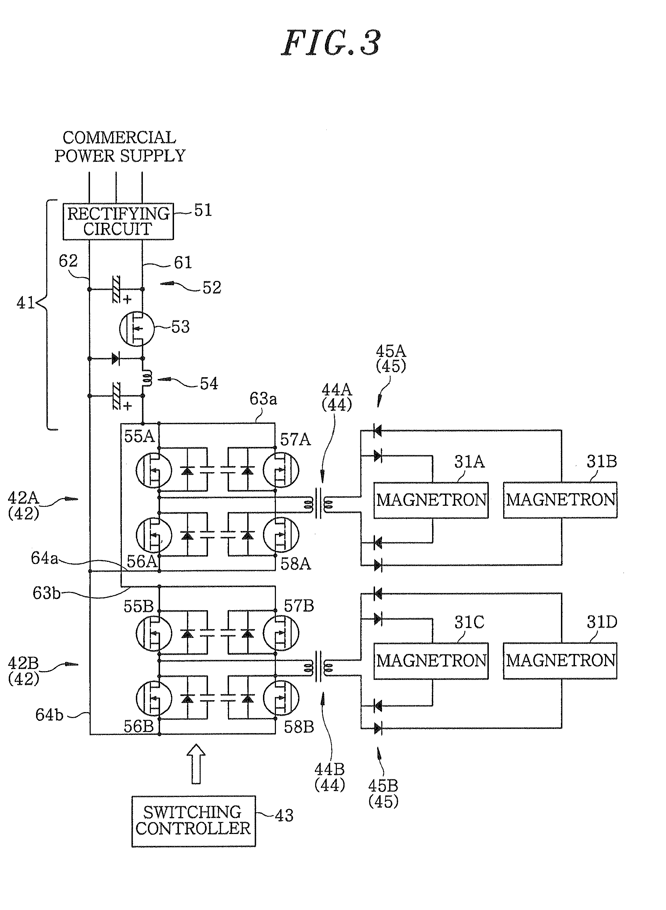

Hereinafter, the configuration of the microwave introducing unit 3 will be described in detail with reference to Figs. 1 to 4. Fig. 2 is an explanatory view showing a schematic configuration of a high voltage power supply unit of the microwave introducing unit 3. Fig.3 is a circuit diagram showing an example of a circuit configuration of the high voltage power supply unit of the microwave introducing unit 3. Fig. 4 is a plane view showing a top surface of the ceiling portion 11 of the processing chamber 2 shown in Fig. 1.

As described above, the microwave introducing unit 3 is provided at a top portion of the processing chamber 2, and serves as a microwave introducing mechanism for introducing electromagnetic waves (microwaves) into the processing chamber 2. As shown in Fig. 1, the microwave introducing unit 3 includes a plurality of microwave units 30 for introducing microwaves into the processing chamber 2 and a high voltage power supply unit 40 connected to the microwave units 30.

### (Microwave Units)

In the present embodiment, the microwave units 30 have the same configuration. Each of the microwave units 30 includes a magnetron 31 for generating microwaves for processing the wafer W, a waveguide 32 for transferring the microwaves generated by the magnetron 31 to the processing chamber 2, a transmission window 33 fixed at the ceiling portion 11 to block the microwave inlet port 11a. The magnetron 31 and the waveguide 32 correspond to a microwave source and a transmission path, respectively, in accordance with the embodiment of the present invention.

As shown in Fig. 4, in the present embodiment, the processing chamber 2 includes, e.g., four microwave inlet ports 11a spaced apart from each other at a regular interval along the circumferential direction of the ceiling unit 11. In the present embodiment, the number of the microwave units 30 is, e.g., four. Hereinafter, reference numerals 31A, 31B, 31C and 31D are used to refer the magnetrons 31 of the four microwave units 3. In Fig. 4, upper, lower, left and right microwave inlet ports 11a introduce microwaves generated by, e.g., the magnetrons 31A to 31D, into the processing chamber 2, respectively.

Each of the magnetrons 31 has an anode and a cathode to which a high voltage supplied by the high voltage power supply unit 40 is applied. Further, as for the magnetron 31, one capable of oscillating microwaves of various frequencies can be used. The optimum frequency of the microwave generated by the magnetron 31 is selected depending on types of processing of the wafer W as an object to be processed. For example, in an annealing process, the microwave of a high frequency such as 2.45 GHz, 5.8 GHz or the like is preferably used, and the microwave of 5.8 GHz is more preferably used.

The waveguide 32 is formed in a tubular shape having a rectangular or an annular cross section, and extends upward from the top surface of the ceiling portion 11 of the processing chamber 2. The magnetron 31 is connected to the vicinity of the top end portion of the waveguide 32. The bottom end portion of the waveguide 32 is brought into contact with the top surface of the transmission window 33. The microwave generated by the magnetron 31 is introduced into the processing chamber 2 through the waveguide 32 and the transmission window 33.

The transmission window 33 is made of dielectric material, e.g., quartz, ceramics, or the like.

The microwave unit 30 further includes a circulator 34, a detector 35 and a tuner 36 which are disposed on the waveguide 32, and a dummy load 37 connected to the circulator 34. The circulator 34, the detector 35 and the tuner 36 are arranged in that order from the top end portion of the waveguide. The circulator 34 and the dummy load 37 form an isolator for isolating reflection waves from the processing chamber 2. In other words, the circulator 34 transmits the reflection waves from the processing chamber 2 to the dummy load 37, and the dummy load 37 transforms the reflection waves transmitted from the circulator 34 into a heat.

The detector 35 detects the reflection wave from the processing chamber 2 on the waveguide 32. The detector 35 is, e.g., an impedance monitor. Specifically, the detector 35 is formed by a standing wave monitor for detecting an electric field of a standing wave on the wave guide 32. The standing wave monitor can be formed by, e.g., three pins projecting into the inner space of the waveguide 32. The reflection wave from the processing chamber 2 can be detected by detecting the location, phase and intensity of the electric field of the standing wave by using the standing wave monitor. Further, the detector 35 may be formed by a directional coupler capable of detecting a traveling wave and a reflection wave.

The tuner 36 performs matching between the magnetron 31 and the processing chamber 2. The impedance matching by the tuner 36 is performed based on a detection result of the reflection wave by the detector 35. The tuner 36 includes, e.g., a conductive plate that can be inserted into and removed from the waveguide 32. In this case, the impedance between the magnetron 31 and the processing chamber 2 can be controlled by adjusting the power of the reflection wave by controlling the projecting amount of the conductive plate into the inner space of the waveguide 32.

### (High Voltage Power Supply Unit)

The high voltage power supply unit 40 supplies a high voltage to the magnetron 31 for generating a microwave. As shown in Fig. 2, the high voltage power supply unit 40 includes an AC-DC conversion circuit 41 connected to a commercial power supply, a switching circuit 42 connected to the AC-DC conversion circuit 41, a switching controller 43 for controlling an operation of the switching circuit 42, a boosting transformer 44 connected to the switching circuit 42, and a rectifying circuit 45 connected to the boosting transformer 44. The magnetron 31 is connected to the boosting transformer 44 via the rectifying circuit 45.

The AC-DC conversion circuit 41 rectifies an AC (e.g., three-phase 200V AC) supplied from the commercial power supply and converting it to a DC having a predetermined waveform. The switching circuit 42 controls on/off of the DC converted by the AC-DC conversion circuit 41. The switching controller 43 includes, e.g., a CPU or field-programmable gate array (FPGA) to generate a pulse width modulation (PWM) signal for controlling the switching circuit 42. The switching controller 43 performs PWM control of the switching circuit 42, to thereby generate a pulsed voltage waveform. The boosting transformer 44 boosts the voltage waveform outputted from the switching circuit 42 to a predetermined level. The rectifying circuit 45 rectifies the voltage boosted by the boosting transformer 44 and supplies the rectified voltage to the magnetron 31.

Hereinafter, an example of the configuration of the high voltage power supply unit 40 in a case where the microwave introducing unit 3 includes four microwave units 30 (magnetrons 31) will be described with reference to Fig. 3. In this example, the high voltage power supply unit 40 includes a single AC-DC conversion circuit 41, two switching circuits 42A and 42B, a single switching controller 43, two boosting transformers 44A and 44B, and two rectifying circuits 45A and 45B.

The AC-DC conversion circuit 41 includes: a rectifying circuit 51 connected to the commercial power supply; a smoothing circuit 52 connected to the rectifying circuit 51; a smoothing circuit 54 connected to the switching circuit 42; and a power FET 53, provided between the smoothing circuits 52 and 54, for improving a power factor. The rectifying circuit 51 has two output ends. The smoothing circuit 52 is formed by a capacitor provided between two wires 61 and 62 connected to the two output ends of the rectifying circuit 51. The power FET 53 is disposed on the wire 61. The rectifying circuit 54 has a coil disposed on the wire 61 and a capacitor provided between the wires 61 and 62.

The switching circuit 42A controls on/off of the DC converted by the AC-DC conversion circuit 41 and outputs a positive current and a negative current to the boosting transformer 44A by generating a pulsed voltage waveform. The switching circuit 42A has four switching transistors 55A, 56A, 57A and 58A forming a full bridge circuit (also referred to as "H-bridge"). The switching transistors 55A and 56A are connected in series and disposed between a wire 63a connected to the wire 61 and a wire 64a connected to the wire 62. The switching transistors 57A and 58A are connected in series and disposed between the wires 63a and 64a. The switching circuit 42A further has resonant capacitors connected in parallel to the switching transistors 55A to 58A, respectively.

In the same manner, the switching circuit 42B controls an on/off operation of the DC converted by the AC-DC conversion circuit 41 and outputs a positive current and a negative current to the boosting transformer 44B by generating a pulsed voltage waveform. The switching circuit 42B has four switching transistors 55B, 56B, 57B and 58B forming a full bridge circuit. The switching transistors 55B and 56B are connected in series and disposed between a wire 63b connected to the wire 61 and a wire 64b connected to the wire 62. The switching transistors 57B and 58B are connected in series and disposed between the wires 63b and 64b. The switching circuit 42B further has resonant capacitors connected in parallel to the switching transistors 55B to 58B, respectively.

In view of efficiency, an FET (Field Effect Transistor) can be used for the switching transistors 55A to 58A and 55B to 58B. As for the FET used for the switching transistors 55A to 58A and 55B to 58B, it is preferable to use a MOSFET, and more preferably to use a power MOSFET. Further, instead of the MOSFET, it is also possible to use an IGBT (Insulated Gate Bipolar Transistor) having a higher withstanding voltage than the MOSFET and suitable for high power.

The boosting transformer 44A has two input terminals and two output terminals. One of the two input terminals of the boosting transformer 44A is connected between the switching transistors 55A and 56A, and the other input terminal is connected between the switching transistors 57A and 58A. In the same manner, the boosting transformer 44B has two input terminals and two output terminals. One of the two input terminals of the boosting transformer 44B is connected between the switching transistors 55B and 56B, and the other input terminal is connected between the switching transistors 57B and 58B.

The rectifying circuit 45A includes two diodes connected to one of the two output terminals of the boosting transformer 44A and two diodes connected to the other output terminal thereof. The magnetron 31A is connected to the boosting transformer 44A through two diodes respectively connected to the two output terminals of the boosting transformer 44A. The magnetron 31B is connected to the boosting transformer 44A through other two diodes respectively connected to the two output terminals of the boosting transformer 44A. The four diodes of the rectifying circuit 45A are arranged such that the direction of the current flowing from the boosting transformer 44A toward the magnetron 31A becomes opposite to the direction of the current flowing from the boosting transformer 44A toward the magnetron 31B.

In the same manner, the rectifying circuit 45B includes two diodes connected to one of the two output terminals of the boosting transformer 44B and two diodes connected to the other output terminal thereof. The magnetron 31C is connected to the boosting transformer 44B through two diodes respectively connected to the two output terminals of the boosting transformer 44B. The magnetron 31D is connected to the boosting transformer 44B through other two diodes respectively connected to the two output terminals of the boosting transformer 44B. The four diodes of the rectifying circuit 45B are arranged such that the direction of the current flowing from the boosting transformer 44B toward the magnetron 31C becomes opposite to the direction of the current flowing from the boosting transformer 44B toward the magnetron 31D.

### [Processing Sequence]

Hereinafter, the sequence of processes performed in the microwave processing apparatus 1 in the case of performing, e.g., an annealing process, on the wafer W will be described. First, a command is inputted from the user interface 82 to the process controller 81 so that an annealing process can be performed by the microwave processing apparatus 1. Next, the process controller 81 receives the command and retrieves a recipe stored in the storage unit 83 or a computer-readable storage medium. Then, the process controller 81 transmits control signals to the end devices of the microwave processing apparatus 1 (e.g., the microwave introducing unit 3, the supporting unit 4, the gas supply unit 5, the gas exhaust unit 6 and the like) so that the annealing process can be performed under the conditions based on the recipe.

Thereafter, the gate valve G is opened, and the wafer W is loaded into the processing chamber 2 through the gate valve G and the loading/unloading port 12a by a transfer unit (not shown). The wafer W is mounted on the supporting pins 14. Then, the gate valve G is closed, and the processing chamber 2 is vacuum-evacuated by the gas exhaust unit 6. At this time, the opening/closing valve 20 is opened, so that the wafer W can be adsorptively fixed on the supporting pins 44 by attracting the rear surface thereof. Then, the predetermined amounts of the processing gas and the cooling gas are introduced by the gas supply unit 5. The inner space of the processing chamber 2 is controlled at a specific pressure by controlling the gas exhaust amount and the gas supply amount.

Next, a microwave is generated by applying a voltage from the high voltage power supply unit 40 to the magnetron 31. The microwave generated by the magnetron 31 passes through the waveguide 32 and the transmission window 33 and then is introduced into the space above the wafer W in the processing chamber 2. In this embodiment, a plurality of microwaves is generated by a multiplicity of magnetrons 31 and is introduced into the processing chamber 2 at the same time. The method for generating a plurality of microwaves at the same time by the plurality of microwaves 31 will be described in detail later.

The microwaves introduced into the processing chamber 2 is irradiated onto the surface of the wafer W, so that the wafer W is rapidly heated by electromagnetic wave heating such as joule heating, magnetic heating, induction heating or the like. As a result, the wafer W is annealed.

When the process controller 81 transmits a control signal to each end device of the microwave processing apparatus 1 to complete the plasma processing, the generation of the microwave is stopped and, also, the supply of the processing gas and the cooling gas is stopped. Thus, the annealing process for the wafer W is completed. Thereafter, the gate valve G is opened, and the wafer W is unloaded by the transfer unit (not shown).

### <Method of Generating Microwaves>

Next, a method of generating a plurality of microwaves simultaneously in the magnetrons 31 will be described in detail with reference to FIG. 3. In the switching circuits 42A and 42B, a PWM control is performed by the switching controller 43, thereby generating a pulsed voltage waveform. That is, PWM signals as gate drive signals respectively controlled by the switching controller 43 are inputted to the switching transistors 55A to 58A and 55B to 58B. The switching circuits 42A and 42B composes these signals to generate pulsed voltage waveforms. The pulsed voltage waveforms may be stored in the storage unit 83 of the control unit 8 in the form of a table in which the pulsed voltage waveforms are associated with the output waveforms (see the below) of the microwaves of the magnetrons 31 and the PWM signals of the switching controller 43.

In the table, the output waveforms of the microwaves in the magnetron 31, the pulsed voltage waveforms for generating them, and the PWM signals for generating the voltage waveforms in the switching circuits 42A and 42B are defined to be associated with each other. Then, for example, based on an instruction from the user interface 82, the switching controller 43 transmits the PWM signals from the table stored in the storage unit 83 in cooperation with the process controller 81 serving as an upper controller so as to obtain pulsed voltage waveforms corresponding to desired output waveforms of the microwaves.

When gate drive signals are inputted to the switching transistors 55A and 58A, a voltage waveform is generated in a positive direction (direction in which a voltage is increased) when seen from the boosting transformer 44A and, at the same time, a current flows in a direction (positive direction) passing the switching transistor 55A, the boosting transformer 44A and the switching transistor 58A in that order. Accordingly, a current is generated at a secondary side (output terminal side) of the boosting transformer 44A in a direction passing the magnetron 31A. Further, the boosting transformer 44A boosts the voltage of the secondary side (output terminal side) of the boosting transformer 44A to be a predetermined level. In this manner, a high voltage for generating a microwave is supplied to the magnetron 31A, and a microwave is generated by the magnetron 31A.

When gate drive signals are inputted to the switching transistors 56A and 57A, a voltage waveform is generated in a negative direction (direction in which a voltage is decreased) when seen from the boosting transformer 44A and, at the same time, a current flows in a direction (negative direction) passing the switching transistor 57A, the boosting transformer 44A and the switching transistor 56A in that order. As a consequence, a current is generated at a secondary side of the boosting transformer 44A in a direction passing the magnetron 31B. Moreover, the boosting transformer 44A boosts the voltage of the secondary side of the boosting transformer 44A to be a predetermined level. In this manner, a high voltage for generating a microwave is supplied to the magnetron 31B, and a microwave is generated by the magnetron 31B.

When gate drive signals are inputted to the switching transistors 55B and 58B, a voltage waveform is generated in a positive direction when seen from the boosting transformer 44B and, at the same time, a current flows in a direction (positive direction) passing the switching transistor 55B, the boosting transformer 44B and the switching transistor 58B in that order. Accordingly, a current is generated at a secondary side of the boosting transformer 44B in a direction passing the magnetron 31C. Further, the boosting transformer 44B boosts the voltage of the secondary side of the boosting transformer 44B to be a predetermined level. In this manner, a high voltage for generating a microwave is supplied to the magnetron 31C, and a microwave is generated by the magnetron 31C.

When gate drive signals are inputted to the switching transistors 56B and 57B, a voltage waveform is generated in a negative direction when seen from the boosting transformer 44B and, at the same time, a current flows in a direction (negative direction) passing the switching transistor 57B, the boosting transformer 44B and the switching transistor 56B in that order. Hence, a current is generated at a secondary side of the boosting transformer 44B in a direction passing the magnetron 31D. Further, the boosting transformer 44B boosts the voltage of the secondary side of the boosting transformer 44B to be a predetermined level. In this manner, a high voltage for generating a microwave is supplied to the magnetron 31D, and a microwave is generated by the magnetron 31D.

In the present embodiment, the switching controller 43 controls the switching circuits 42A and 42B such that the pulsed microwaves are generated in the magnetrons 31A to 31D. In this embodiment, especially, the switching controller 43 transmits a plurality of PWM signals to the switching circuits 42A and 42B in order to generate the pulsed microwaves. Thus, in the switching circuits 42A and 42B, a plurality of pulsed voltage waveforms are generated. A relationship between pulsed voltage waveform, microwave output and frequency will be described in detail later.

Further, the switching controller 43 controls the switching circuits 42A and 42B (switching transistors 55A, 58A, 55B and 58B) such that a state where the microwave is generated and a state where the microwave is not generated are alternately repeated multiple times in the magnetrons 31A and 31C. Further, the switching controller 43 controls the switching circuits 42A and 42B (switching transistors 56A, 57A, 56B and 57B) such that a state where the microwave is generated and a state where the microwave is not generated are alternately repeated multiple times in the magnetrons 31B and 31D without generating the microwaves at the same time as the magnetrons 31A and 31C. In each of the magnetrons 31A to 31D, a time period of the state where the microwave is generated is, e.g., 20 ms. In this way, two microwaves are generated simultaneously in the magnetrons 31A to 31D and introduced simultaneously into the processing chamber 2. Further, the switching controller 43 is controlled by the process controller 81 of the control unit 8.

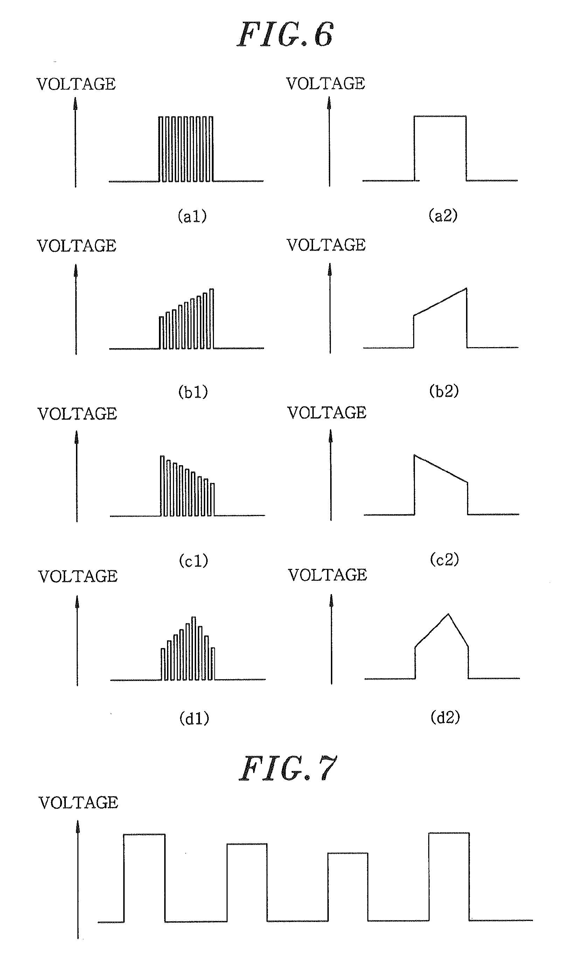

The microwave introduced into the processing chamber 2 forms a standing wave in the processing chamber 2. If positions of nodes and antinodes of the standing wave are fixed during a state of processing the wafer W, there is a possibility of non-uniform process for the wafer W, such as non-uniform heating. Therefore, in the present embodiment, a state of the standing wave in the processing chamber 2 is changed by changing a frequency of a microwave during the state of processing the wafer W. Hereinafter, this will be described in detail with reference to FIGS. 6 and 7.

In general, it has been known that a center frequency of a microwave is changed when an output (power) of the microwave is changed. Specifically, as the output of the microwave increases, the center frequency of the microwave rises. The output of the microwave can be controlled based on a level of a voltage applied to the magnetron 31. Thus, by controlling a magnitude of the voltage applied to the magnetron 31, it is possible to change the frequency of the microwave. For example, in case of the magnetron 31 generating the microwave of 5.8 GHz, it is possible to change the frequency of the microwave in the range of 5.8 GHz ± 193 MHz, by varying the magnitude of the voltage applied to the magnetron 31. The magnitude of the voltage applied to the magnetron 31 can be controlled by the magnitude of the voltage of the pulsed voltage waveform generated in the switching circuit 42.

In this embodiment, the frequency of the microwave is changed by varying the magnitude of the voltage being supplied to the magnetron 31 during the state of processing the wafer W. Accordingly, the state of the standing wave in the processing chamber 2, more specifically, the positions of nodes and antinodes of the standing wave are changed. As a form of changing the frequency of the microwave, there are a first form of changing the frequency of the microwave during at least of the states where the microwave is generated, e.g., during one pulse, and a second form of changing the frequency of the microwave between states where the microwave is generated, i.e., between pulses.

FIG. 6 is an explanatory view schematically showing voltage waveforms for generating a pulsed microwave. In FIG. 6, (a1) and (a2) illustrate an example in which the output of the microwave is constant during one pulse. Further, (b1) and (b2) illustrate an example in which the output of the microwave during one pulse increases. Further, (c1) and (c2) illustrate an example in which the output of the microwave during one pulse decreases. Further, (d1) and (d2) illustrate an example in which the output of the microwave during one pulse decreases after it increases.

In FIG. 6, (a1), (b1), (c1) and (d1) show the voltage waveforms in the primary side (input terminal side) of the boosting transformer 44, i.e., a plurality of pulsed voltage waveforms being generated in the switching circuits 42A and 42B. Further, (a2), (b2), (c2) and (d2) show the voltage waveforms in the secondary side (output terminal side) of the boosting transformer 44, i.e., the voltage waveforms being applied to the magnetron 31. The output of the microwave is changed similarly to the voltage waveform of the secondary side of the boosting transformer 44.

In the above-described embodiment, the switching controller 43 transmits a plurality of PWM signals to the switching circuits 42A and 42B to thereby generate the pulsed microwave. Accordingly, a plurality of pulsed voltage waveforms is generated in the switching circuits 42A and 42B. In FIG. 6, (a1), (b1), (c1) and (d1) show a plurality of pulsed voltage waveforms which are generated in this way. With respect to the frequency of the pulsed voltage waveform higher than a pass band of the boosting transformer 44, the boosting transformer 44 serves as a filter. As a result, the voltage waveform of one pulse is generated in the secondary side of the boosting transformer 44. In FIG. 6, (a2), (b2), (c2) and (d2) show voltage waveforms generated in this way. In the magnetron 31, the pulsed microwave is generated based on one pulse of the voltage waveform on the secondary side of the boosting transformer 44.

Herein, the number of pulses of forming the voltage waveform on the primary side of the boosting transformer 44 required to generate one pulse of the voltage waveform on the secondary side thereof, i.e., the number of the PWM signals required to generate one pulsed microwave is, e.g., hundred (100).

In the meantime, an output of the microwave depends on a voltage level of the voltage waveform on the secondary side of the boosting transformer 44, and the voltage level of the voltage waveform on the secondary side of the boosting transformer 44 depends on voltage levels of pulses forming the voltage waveform on the primary side thereof. As shown in (a1) and (a2) of FIG. 6, when the voltage levels of respective pulses of forming the voltage waveform on the primary side of the boosting transformer 44 are constant, the voltage level of one pulsed voltage waveform on the secondary side thereof becomes constant. In contrast, when the voltage levels of respective pulses forming the voltage waveform on the primary side of the boosting transformer 44 is slightly changed as shown in (b1), (c1) and (d1) of FIG. 6, the voltage level of the pulsed voltage waveform on the secondary side is changed as shown in (b2), (c2) and (d2) of FIG. 6.

In the first form, as shown in (b1) (c1) and (d1) of FIG. 6, by varying the voltage levels of the respective pulses forming the voltage waveform on the primary side of the boosting transformer 44, and varying the voltage level of one pulsed voltage waveform on the secondary side thereof, the output of the microwave during one pulse is changed. Thus, it is possible to change the frequency of the microwave during one pulse. Further, in order to the voltage waveform on the secondary side of the boosting transformer 44 which is constant during one pulse as shown in (a2) of FIG. 6, the voltage of a plurality of pulses as shown in (a1) of FIG. 6 is not necessarily required, and it may be obtained by generating, e.g., a single rectangular voltage waveform.

FIG. 7 is an explanatory view schematically showing a voltage waveform for generating a microwave in the second form. Further, FIG. 7 illustrates a voltage waveform of the secondary side of the boosting transformer 44 as the voltage waveform for generating the microwave, like the waveforms shown in (a2), (b2), (c2) and (d2) of FIG. 6. Further, similarly to the first form, the output of the microwave is changed based on the voltage waveform of the secondary side of the boosting transformer 44. In the example shown in FIG. 7, the voltage level of the voltage waveform is changed between states where the microwave is generated, i.e., between pulses.

In FIG. 7, a first pulse, a second pulse, a third pulse, and a fourth pulse are illustrated from the left side. With respect to each pulse, the voltage level of the voltage waveform is constant similarly to the example shown in (a2) of FIG. 6, but the voltage level of the voltage waveform varies among the first to fourth pulses, thereby changing arbitrarily the frequency and the output of the microwave between pulses.

In the example shown in FIG. 7, the voltage level of the voltage waveform in the first pulse is the same as that in fourth pulse. The voltage level of the voltage waveform in the second pulse is smaller than that in the first pulse, and the voltage level of the voltage waveform in the third pulse is smaller than that in the second pulse. In this case, for example, by repeatedly outputting a unit formed of the first to third pulses, the microwave may be controlled such that the frequency and the output of the microwave are slightly changed per the unit of multiple pulses.

As mentioned above, controlling the voltage waveform (the voltage waveform of the secondary side of the boosting transformer 44) for generating the pulsed microwave may include changing the voltage level of the voltage waveform during one pulse, changing the voltage level of the voltage waveform in a pulse basis, and a combination of both. Further, controlling the frequency of the microwave may include varying the frequency during one pulse, varying the frequency between pulses, and a combination of both.

Further, the form of changing the frequency of the microwave is not limited to the first form shown in FIG. 6 and the second form shown in FIG. 7. For example, as a form of changing the frequency of the microwave, the first form and the second form may be combined with each other. Further, the frequency of the microwave may be varied independently for each magnetron 31, or the frequency of the microwave may be varied while linking the magnetrons 31.

Next, effects of the microwave processing apparatus 1 and the method for processing the wafer W using the microwave processing apparatus 1 in accordance with the embodiment of the present invention will be described. In the above-described embodiment, the frequency of the microwave is changed during the state of processing the wafer W. In this embodiment, especially, the frequency of the microwave is actively changed by controlling the magnitude (level) of the voltage applied to the magnetron 31. Accordingly, in this embodiment, the state of the standing wave in the processing chamber 2, more specifically, the positions of nodes and antinodes of the standing wave can be changed. As a result, with the embodiment of the present invention, uniform processing can be performed on the wafer W.

Further, the microwave processing apparatus 1 of the present embodiment includes the stirrer fan 91 configured to reflect and stir microwaves introduced into the processing chamber 2 by rotation. In the present embodiment, it is possible to more effectively change the state of the standing wave in the processing chamber 2 by using the stirrer fan 91 as well.

Further, the microwave introducing unit 3 in the present embodiment has a plurality of magnetrons 31 and a plurality of waveguides 32. Accordingly, in this embodiment, it is possible to change the magnetron 31 used to generate the microwave during the state of processing the wafer W. Therefore, according to the embodiment of the present invention, it is possible to more effectively change the state of the standing wave in the processing chamber 2.

Furthermore, in the present embodiment, the microwave introducing unit 3 can introduce a plurality of microwaves simultaneously into the processing chamber 2. When a plurality of microwaves are introduced simultaneously into the processing chamber 2, there is a case where the standing wave based on the plurality of microwaves is formed in addition to the standing wave based on each microwave. With the present embodiment, it is possible to change the state of the standing wave based on the plurality of microwaves by varying the frequency of at least one microwave.

As a result, with the embodiment of the present invention, even if microwaves are introduced simultaneously into the processing chamber 2, uniform processing can be performed on the wafer W. In addition, by making the frequencies of the microwaves being simultaneously introduced into the processing chamber 2 different from each other, it is possible to prevent the standing wave from being formed based on a plurality of microwaves.

Hereinafter, other effects in this embodiment will be described. In the present embodiment, the microwave introducing unit 3 includes a plurality of magnetrons 31 and a plurality of waveguides 32, so that a plurality of microwaves can be introduced simultaneously into the processing chamber 2. In accordance with the present embodiment, even if the output of each magnetron 31 is insufficient for the wafer W, the wafer W can be processed by introducing a plurality of microwaves simultaneously into the processing chamber 2.

In the present embodiment, the microwave is irradiated onto the wafer W in order to process the wafer W. Therefore, in accordance with the present embodiment, heat treatment can be performed on the wafer W at a temperature lower than that of plasma processing.

The present invention is not limited to the above-described embodiment and can be variously modified. For example, the microwave processing apparatus of the present invention is not limited to the case of processing a semiconductor wafer, and may be applied to the case of processing, e.g., a substrate of a solar cell panel or a substrate for flat panel display.

In addition, although the example in which the magnetrons 31A and 31B are connected to the boosting transformer 44A and the magnetrons 31C and 31D are connected to the boosting transformer 44B has been described in the present embodiment, each of the magnetrons 31A to 31D may be connected to a separate boosting transformer. In this case, the combination of the magnetrons 31A to 31D used to generate microwaves simultaneously can be varied arbitrarily.

Further, the number of the microwave units 30 (i.e., the number of the magnetrons 31) or the number of the microwaves simultaneously introduced into the processing chamber 2 is not limited to that described in the embodiment.

While the invention has been shown and described with respect to the embodiments, it will be understood by those skilled in the art that various changes and modification may be made without departing from the scope of the invention as defined in the following claims.

## Claims

1. A microwave processing apparatus comprising:
a processing chamber which accommodates an object to be processed;
a microwave introducing unit which has at least one microwave source to generate a microwave used to process the object and introduces the microwave into the processing chamber; and
a control unit which controls the microwave introducing unit,
wherein the control unit changes a frequency of the microwave during a state of processing the object.

2. The microwave processing apparatus of claim 1, wherein during the state of processing the object, a state where the microwave is generated and a state where the microwave is not generated are alternately repeated multiple times, and
wherein the control unit changes the frequency of the microwave during at least of the states where the microwave is generated.

3. The microwave processing apparatus of claim 1, wherein during the state of processing the object, a state where the microwave is generated and a state where the microwave is not generated are alternately repeated multiple times, and
wherein the control unit changes the frequency of the microwave between states where the microwave is generated.

4. The microwave processing apparatus of any one of claims 1 to 3, wherein the microwave source generates the microwave based on a voltage applied to the microwave source, and
wherein the control unit changes the frequency of the microwave by changing the voltage applied to the microwave source.

5. The microwave processing apparatus of any one of claims 1 to 4, wherein the microwave introducing unit includes a plurality of microwave sources which generate microwaves and transmission paths which transmits the microwaves generated in the microwave sources to the processing chamber.

6. The microwave processing apparatus of claim 5, wherein the microwave introducing unit can introduce at least a part of the microwaves simultaneously into the processing chamber.

7. The microwave processing apparatus of any one of claims 1 to 6, wherein the microwave is irradiated onto the object to process the object.

8. A method for processing an object to be processed by using a microwave processing apparatus including a processing chamber which accommodates the object, and a microwave introducing unit which has at least one microwave source to generate a microwave used to process the object and introduces the microwave into the processing chamber, the method comprising:
changing a frequency of the microwave during a state of processing the object.

9. The method of claim 8, wherein, during the state of processing the object, a state where the microwave is generated and a state where the microwave is not generated are alternately repeated multiple times, and
wherein the frequency of the microwave is changed during at least of the states where the microwave is generated.

10. The method of claim 8, wherein, during the state of processing the object, a state where the microwave is generated and a state where the microwave is not generated are alternately repeated multiple times, and
wherein the frequency of the microwave is changed between states where the microwave is generated.

11. The method of any one of claims 8 to 10, wherein the microwave source generates the microwave based on a voltage applied to the microwave source, and
wherein the frequency of the microwave is changed by changing the voltage applied to the microwave source.

12. The method of any one of claims 8 to 11, wherein the microwave introducing unit includes a plurality of microwave sources to generate microwaves and transmission paths to transmit the microwaves generated in the microwave sources to the processing chamber.

13. The method of claim 12, wherein the microwave introducing unit can introduce at least a part of the microwaves simultaneously into the processing chamber.

14. The method of any one of claims 8 to 13, wherein the microwave is irradiated onto the object to process the object.
